# EUROPÄISCHE PATENTSCHRIFT

(11) **EP 0 616 365 B1**
(45) Veröffentlichungstag und Bekanntmachung des Hinweises auf die Patenterteilung: **14.01.1998**
(21) Anmeldenummer: 94102536.3
(22) Anmeldetag: 19.02.1994
(51) Int. Cl.: H01L 29/745, H01L 29/739, H01L 29/78, H01L 29/43, H01L 23/29, H01L 23/60, H01L 27/02

(54) **MOS-gesteuertes Leistungshalbleiterbauelement**
MOS-controlled power semiconductor device
Dispositif semi-conducteur de puissance, contrôlé par MOS

(30) Priorität: 18.03.1993 DE 4308624
(43) Veröffentlichungstag der Anmeldung: 21.09.1994
(73) Patentinhaber: ASEA BROWN BOVERI AG, 5400 Baden (CH)
(72) Erfinder: Stockmeier, Thomas, Dr., CH-5405 Baden-Dättwil (CH); Thiemann, Uwe, Dr., D-79793 Wutöschingen (DE)

(56) Entgegenhaltungen:
- EP-A- 0 304 929
- EP-A- 0 433 650
- FR-A- 2 333 348
- GB-A- 2 071 411
- US-A- 4 134 125
- PATENT ABSTRACTS OF JAPAN vol. 11, no. 237 (E-528)4. August 1987 & JP-A-62 051 260

## Beschreibung

### Technisches Gebiet

Die Erfindung bezieht sich auf das Gebiet der Leistungselektronik. Sie geht aus von einem MOS-gesteuerten Leistungshalbleiterbauelement nach dem Oberbegriff des ersten Anspruchs.

### Stand der Technik

Ein solches Leistungshalbleiterbauelement ist als MCT (MOS gesteuerter Thyristor) schon im Artikel von V.A.K. Temple ("MOS-Controlled Thyristors - A New Class of Power Devices", IEEE Trans. on Electron Devices, Vol. ED-33, No. 10, Oktober 1986), bzw. als IGBT (Insulated Gate Bipolar Transistor) im Artikel von B.J. Baliga ("Evolution of MOS Bipolar Power Semiconductor Technology", Proceedings of the IEEE, Vol. 76, No. 4, April 1988) beschrieben. Weitere Beispiele solcher Leistungshalbleiterbauelement können der Europäischen Patentanmeldung EP 0 433 650 A1 entnommen werden. Bei dem aus EP-A-0 304 929 bekannten MOS-Leistungshalbleiterbauelement ist eine halbisolierende Schutzschicht auf der MOS-Struktur angeordnet.

MOS-gesteuerte Leistungshalbleiterbauelemente umfassen ein Halbleitersubstrat mit mindestens einer MOS-Struktur. Mittels Anlegen einer Spannung an die Gateelektrode der MOS-Struktur kann der Stromfluss von einer ersten zu einer zweiten Hauptelektrode ein- und ausgeschaltet werden.

Das Gate ist gegenüber dem Halbleitersubstrat durch eine sog. Gateoxidschicht isoliert angeordnet. Die Isolation zur Metallisierung der Hauptelektrode erfolgt durch eine oder mehrere Isolationsschichten (z.B. Siliziumoxid) zwischen dem Gate und der Metallisierung.

Diese Isolierung des Steuergates bewirkt, dass das Bauelement durch dielektrischen Durchbruch des Isolationsoxids, hervorgerufen durch elektrostatische Aufladung, zerstört werden kann. Dies kann bereits während der Herstellung der Bauelemente, aber auch in der anschliessenden Test- und Einbauphase oder während des Betriebs geschehen. Der Fehler führt jeweils zu einem Totalverlust der funktionellen Eigenschaften.

### Darstellung der Erfindung

Aufgabe der vorliegenden Erfindung ist es deshalb, ein MOS-gesteuertes Leistungshalbleiterbauelement anzugeben, welches durch dielektrische Durchbrüche nicht zerstört werden kann. Das Bauelement soll dennoch möglichst einfach aufgebaut sein.

Diese Aufgabe wird bei einem MOS-gesteuerten Leistungshalbleiterbauelement der eingangs genannten Art durch die Merkmale des ersten Anspruchs gelöst.

Kern der Erfindung ist es also, dass zum Schutz gegen Zerstörung des Halbleiterbauelements durch dielektrische Durchbrüche eine halbisolierende Schicht zwischen der die Hauptelektrode bildenden Metallisierung und der Gate-Schicht angeordnet ist. Diese halbisolierende Schicht weist vorzugsweise eine Strom-Spannungscharakteristik vom Typ eines Varistors auf. Weitere Ausführungsbeispiele ergeben sich aus den Unteransprüchen.

Der Vorteil des erfindungsgemässen Aufbaus besteht also darin, dass das Halbleiterbauelement einen integrierten Schutz gegen Zerstörung durch dieelektrische Durchbrüche aufweist. Da die Mittel zum Schutz gleichzeitig die Trennung von Gateelektrode und Hauptelektrode darstellen, werden keine zusätzlichen Prozesschritte oder Masken benötigt.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt eines erfindungsgemässen MOS-gesteuerten Leistungshalbleiterbauelements im Schnitt; und
- **Fig. 2**: Die Strom-Spannungskennlinie der erfindungsgemässen, halbisolierenden Schicht.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

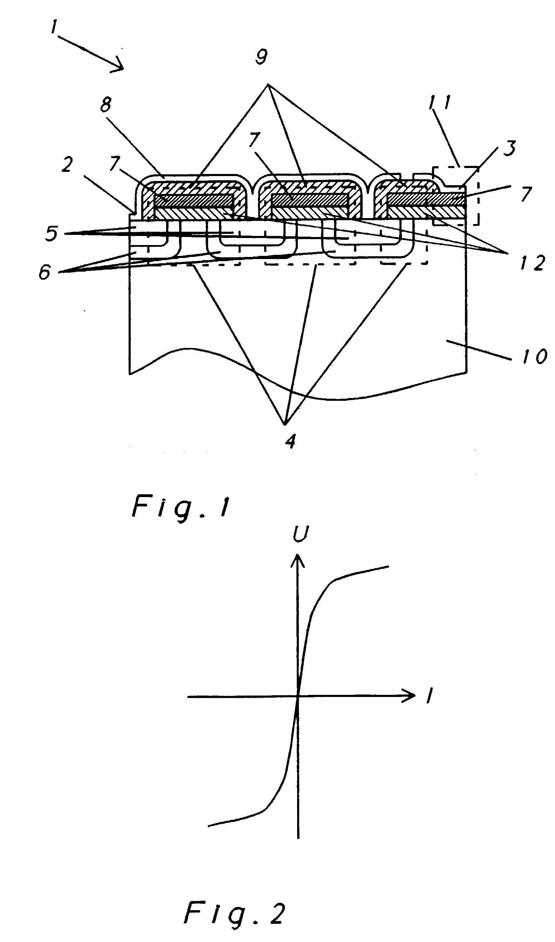

Figur 1 zeigt im Schnitt einen Ausschnitt eines erfindungsgemässen, MOS-gesteuerten Leistungshalbleiterbaulements (1). Ein solches Halbleiterbauelement umfasst ein Halbleitersubstrat (10) mit mehreren, eingelassenen MOS-Strukturen (4). Über dem Halbleitersubstrat (10) ist eine Gateelektrode (3) angeordnet. Mittels Anlegen einer Spannung an der Gateelektrode kann der Stromfluss zwischen zwei Hauptelektroden ein- bzw. ausgeschaltet werden. Von den Hauptelektroden befindet sich die eine auf der dargestellten Oberfläche des Halbleitersubtrats und die andere auf der nicht dargestellten, gegenüberliegenden Oberfläche.

Die MOS-Strukturen (4) umfassen eine in das Halbleitersubstrat (10) eindiffundierte Wanne (5) und ein diese Wanne (5) umgebendes Kanalgebiet (6). Wanne (5) und Halbleitersubstrat (10) sind i.a. vom gleichen Leitungstyp, während das Kanalgebiet vom entgegengesetzten Leitungstyp ist. Die Gateelektrode (3) wird durch eine leitende Schicht (7) gebildet, welche von der einen Wanne (5) über das zugeordnete Kanalgebiet (6), das zwischen zwei MOS-Strukturen liegende Halbleitersubstrat (10) sowie über das benachbarte Kanalgebiet zur benachbarten Wanne (5) reicht. Die Isolierung zwischen Gate-Schicht (7), Halbleitersubstrat (10) und Hauptelektrode (2) wird durch ein die Gate-Schicht (7) umgebende Schicht (9) gebildet. Die Gate-Schicht (7) wird vom Halbleitersubstrat (10) durch ein Gateoxid (12), welches direkt zwischen der Gate-Schicht (7) und dem Halbleitersubstrat (10) liegt, isoliert. Die Hauptelektrode (2) ist als Metallschicht (8) ausgebildet, welche die isolierende Schicht (9) überdeckt und das Halbleitersubstrat (10) in den von der Gate-Schicht (7) nicht bedeckten Gebieten der Wannen (5), den Kontaktlöchern, kontaktiert.

An einer Stelle, im Gatekontaktbereich (11), ist die Gate-Schicht freigelegt, und die Gateelektrode (3) kontaktiert die leitende Gate-Schicht (7).

Nach dem Stand der Technik wird die Gate-Schicht (7) beispielsweise durch ein Poly-Silizium-Schicht gebildet. Die umgebende Schicht (9) besteht jedoch aus einem isolierenden Material, insbesondere aus Siliziumoxid. Diese Isolation des Steuergates bewirkt, dass das Bauelement durch dielektrischen Durchbruch des Isolationsoxids, hervorgerufen durch elektrostatische Aufladung, zerstört werden kann. Für eine solche Aufladung genügt beispielsweise einfaches Berühren. Der Schaden ist jeweils irreparabel, und ein beschädigtes Element kann nicht mehr gebraucht werden.

Das Ziel der Erfindung ist es, eine begrenzte Leitfähigkeit zwischen der Hauptelektrode und der Gateelektrode herzustellen. Dies wird dadurch erreicht, dass das Isolationsoxid durch eine halbisolierende Schicht (9) ersetzt wird. Aufgrund des begrenzten Stromflusses zwischen Gate und Hauptelektrode wird der Aufbau einer Potentialdifferenz zwischen Gate und Hauptelektrode verunmöglicht. Damit ist es nicht mehr möglich, das Bauelement durch elektrostatische Aufladung zu zerstören.

Der Kontakt zwischen Gate (3) und Hauptelektrode (2) kommt zustande, da sowohl die Metallisierung (8) der Hauptelektrode als auch die leitende Schicht (7) der Gateelektrode die halbisolierende Schicht in den Kontaktlöchern seitlich kontaktieren.

Im Herstellungsprozess ersetzt die halbisolierende Schicht (9) die Isolationsschicht zwischen Gate und Hauptelektrode. Deshalb werden kein zusätzlichen Prozesschritte oder Photomasken benötigt. Wird die gleiche halbisolierende Schicht (9) auch für die Passivierung des Randabschlusses verwendet, so können im Gegenteil nicht nur Masken, sondern auch eine Reihe von Prozesschritten eingespart werden.

Die halbisolierende Schicht (9) zeichnet sich durch ein nichtlineares Strom-Spannungsverhalten aus, wie es beispielsweise Varistoren aufweisen (siehe **Figur 2**). Ab einer bestimmten Spannung, z.B. ca. 20 V, nimmt der Strom überproportional zu, womit eine Spannungsbegrenzung eintritt. Ein solches Verhalten kann beispielsweise mit sauerstoffhaltigem Polysilizium (SIPOS) erzeugt werden. Durch den Sauerstoffgehalt in der SIPOS-Schicht kann der spezifische Widerstand typisch zwischen 10⁶ Ωcm und 10⁹ ncm variiert werden. Im einen Extremfall erhält man reines Polysilizium, im anderen Siliziumoxid. Die SIPOS-Schicht wird vorzugsweise in ein Tiefdruck-Dampfabscheidungsprozess (LPCVD) oder einen plasmaunterstützten Dampfabscheidungsprozess (PECVD) aufgebracht.

Üblicherweise umfasst das Halbleitersubstrat (10) mehrere Schichten unterschiedlicher Dotierung. Insbesondere weist es die Struktur eines Power-MOSFETs, eines MCTs, eines IGBTs oder eine anderen MOS-gesteuerten Leistungshalbleiterbauelements auf.

Bei einem experimentell aufgebauten Bauelement zeigte sich, dass der Leckstrom zwischen Gate und Hauptelektrode, gemessen bei einer angelegten Spannung von 10 V, gegenüber einem Bauteil mit Isolationsschicht von 10⁻⁹ A auf 10⁻⁸ A anstieg. Die Ausbeute an funktionstüchtigen Bauelement war dabei mit durchschnittlich über 80% deutlich höher als bei bisherigen Bauelementen.

Insgesamt steht also mit der Erfindung ein MOS-gesteuertes Leistungshalbleiterbauelement zur Verfügung, welches einen Schutz gegen dielektrische Durchbrüche aufweist und trotzdem einfach hergestellt werden kann.

### Bezeichnungsliste

- 1: Halbleiterbauelement
- 2: Hauptelektrode
- 3: Gateelektrode
- 4: MOS-Struktur
- 5: eingelassene Wanne
- 6: Kanalgebiet
- 7: leitende Gate-Schicht
- 8: Hauptelektroden-Metallisierung
- 9: halbisolierende Schicht
- 10: Halbleitersubstrat
- 11: Gatekontaktbereich
- 12: Gateoxid
- U: Spannung
- I: Strom

## Patentansprüche

1. MOS-gesteuertes Leistungshalbleiterbauelement (1) umfassend
a) ein Halbleitersubstrat (10), mit mindestens einer MOS-Struktur (4), wobei
b) die MOS-Struktur (4) eine über dem Halbleitersubstrat (10) isoliert angeordnete, leitende Gate-Schicht (7) umfasst, und das Halbleiterbauelement (1) mittels Anlegen einer Spannung an eine mit der Schicht (7) verbundenen Gateelektrode (3) ein- und ausgeschaltet werden kann;
c) eine Hauptelektrode (2), welche mit dem Halbleitersubstrat (10) in Kontakt steht und durch eine über der Gate-Schicht (7) angeordnete Metallisierung (8) gebildet wird;
dadurch gekennzeichnet, dass
d) zum Schutz gegen Zerstörung des Halbleiterbauelements (1) durch dielektrische Durchbrüche eine halbisolierende Schicht (9) zwischen der Metallisierung (8) und der Gate-Schicht (7) angeordnet ist.

2. Halbleiterbauelement nach Anspruch 1, dadurch gekennzeichnet, dass die Kontaktierung der Gateelektrode (3) mit der leitenden Gate-Schicht (7) in einem Gatekontaktbereich (11) erfolgt, welcher nicht mit der halbisolierenden Schicht (9) bedeckt ist.

3. Halbleiterbauelement nach Anspruch 2, dadurch gekennzeichnet, dass
a) die MOS-Struktur (4) eine Wanne (5) umfasst, welche in das Halbleitersubstrat (10) eingelassen ist und von einem Kanalgebiet (6) umgeben ist;
b) die Hauptelektrode (2) in Kontakt mit der Wanne (5) steht; und
c) sich die leitende Gate-Schicht (7) von der Wanne (5) über das zugeordnete Kanalgebiet (6), das zwischen zwei benachbarten MOS-Strukturen (4) liegende Halbleitersubstrat (10) sowie über das benachbarte Kanalgebiet (6) zur daneben liegenden Wanne (5) erstreckt.

4. Halbleiterbauelement nach Anspruch 3, dadurch gekennzeichnet, dass das Halbleitersubstrat (10) mehrere Schichten unterschiedlicher Dotierung umfasst.

5. Halbleiterbauelement nach Anspruch 4, dadurch gekennzeichnet, dass das Halbleitersubstrat ein Struktur eines Leistungs-MOSFETs, eines MCTs, eines IGBTs oder eines anderen MOS-gesteuerten Leistungshalbleiterbauelements aufweist.

6. Halbleiterbauelement nach Anspruch 1, dadurch gekennzeichnet, dass die halbisolierende Schicht (9) eine nichtlineare Strom-Spannungskennlinie vom Typ eines Varistors aufweist.

7. Halbleiterbauelement nach Anspruch 6, dadurch gekennzeichnet, dass die halbisolierende Schicht (9) aus sauerstoffhaltigem Polysilizium besteht.

8. Halbleiterbauelement nach Anspruch 7, dadurch gekennzeichnet, dass der spezifische Widerstand der halbisolierenden Schicht (9) ungefähr 10⁹ Ωcm beträgt.

## Claims

1. MOS-controlled power semiconductor component (1) comprising:
a) a semiconductor substrate (10), having at least one MOS structure (4),
b) the MOS structure (4) comprising a conductive gate layer (7), which is arranged insulated over the semiconductor substrate (10), and it being possible to switch the semiconductor component (1) on and off by applying a voltage to a gate electrode (3) which is connected to the layer (7);
c) a main electrode (2) which is in contact with the semiconductor substrate (10) and is formed by metallization (8) arranged over the gate layer (7);
characterized in that
d) a semi-insulating layer (9) is arranged between the metallization (8) and the gate layer (7) for protection of the semiconductor component (1)

2. Semiconductor component according to Claim 1, characterized in that the gate electrode (3) makes contact with the conductive gate layer (7) in a gate-contact region (11) which is not covered by the semi-insulating layer (9).

3. Semiconductor component according to Claim 2, characterized in that
a) the MOS structure (4) comprises a well (5) which is recessed into the semiconductor substrate (10) and is surrounded by a channel region (6);
b) the main electrode (2) is in contact with the well (5); and
c) the conductive gate layer (7) extends from the well (5) over the associated channel region (6), the semiconductor substrate (10) located between two adjacent MOS structures (4), and over the adjacent channel region (6) to the well (5) located alongside it.

4. Semiconductor component according to Claim 3, characterized in that the semiconductor substrate (10) comprises a plurality of layers of different doping.

5. Semiconductor component according to Claim 4, characterized in that the semiconductor substrate has a structure of a power MOSFET, of an MCT, of an IGBT or of another MOS-controlled power semiconductor component.

6. Semiconductor component according to Claim 1, characterized in that the semi-insulating layer (9) has a non-linear current/voltage characteristic of the varistor type.

7. Semiconductor component according to Claim 6, characterized in that the semi-insulating layer (9) is composed of polysilicon containing oxygen.

8. Semiconductor component according to Claim 7, characterized in that the resistivity of the semi-insulating layer (9) is approximately 10⁹ Ωcm.

## Revendications

1. Dispositif semiconducteur de puissance contrôlé par MOS (1) comprenant
a) un substrat semiconducteur (10) avec au moins une structure MOS (4),
b) la structure MOS (4) comprenant une couche de gâchette (7) conductrice disposée de manière isolée par-dessus le substrat semiconducteur (10), et le dispositif semiconducteur (1) pouvant être ouvert ou fermé en appliquant une tension sur une électrode de gâchette (3) reliée à la couche (7) ;
c) une électrode principale (2) qui est en contact avec le substrat semiconducteur (10) et qui est formée par une métallisation (8) disposée par-dessus la couche de gâchette (7) ;
caractérisé par le fait
d) qu'une couche semi-isolante (9) est disposée entre la métallisation (8) et la couche de gâchette (7) pour assurer la protection contre la destruction du dispositif semiconducteur (1) par les ruptures diélectriques.

2. Dispositif semiconducteur selon la revendication 1, caractérisé par le fait que le contact de l'électrode de gâchette (3) avec la couche de gâchette (7) conductrice est établi dans une zone de contact de gâchette (11) qui n'est pas recouverte par la couche semi-isolante (9).

3. Dispositif semiconducteur selon la revendication 2, caractérisé par le fait que
a) la structure MOS (4) présente une cuve (5) qui est noyée dans le substrat semiconducteur (10) et qui est entourée d'une zone de canal (6) ;
b) l'électrode principale (2) est en contact avec la cuve (5) ; et
c) la couche de gâchette (7) conductrice s'étend de la cuve (5) vers la cuve (5) voisine au-dessus de la zone de canal (6) associée, du substrat semiconducteur (10) qui se trouve entre deux structures MOS (4) voisines et au-dessus de la zone de canal (6) voisine.

4. Dispositif semiconducteur selon la revendication 3, caractérisé par le fait que le substrat semiconducteur (10) comprend plusieurs couches de dopages différents.

5. Dispositif semiconducteur selon la revendication 4, caractérisé par le fait que le substrat semiconducteur présente la structure d'un MOSFET de puissance, d'un MCT, d'un IGBT ou d'un autre dispositif semiconducteur de puissance contrôlé par MOS.

6. Dispositif semiconducteur selon la revendication 1, caractérisé par le fait que la couche semi-isolante (9) présente une caractéristique courant/tension non linéaire du type de celle d'une varistance.

7. Dispositif semiconducteur selon la revendication 6, caractérisé par le fait que la couche semi-isolante (9) est en polysilicium oxygéné.

8. Dispositif semiconducteur selon la revendication 7, caractérisé par le fait que la résistance spécifique de la couche semi-isolante (9) est d'environ 109 Ωcm.
